**Europäisches Patentamt**

**European Patent Office**

**Office européen des brevets**

(19)

(11) Veröffentlichungsnummer : **0 113 465 B1**

(12) **EUROPÄISCHE PATENTSCHRIFT**

(45) Veröffentlichungstag der Patentschrift :
29.07.87

(21) Anmeldenummer : 83112712.1

(22) Anmeldetag : 16.12.83

(51) Int. Cl.⁴ : **H 03 H   1/00,** H 01 R 13/60,
H 05 K   7/02

(54) Elektrisches Entstörfilter.

(30) Priorität : 22.12.82 DE 3247546
29.03.83 DE 3311443

(43) Veröffentlichungstag der Anmeldung :
18.07.84 Patentblatt 84/29

(45) Bekanntmachung des Hinweises auf die Patenterteilung : 29.07.87 Patentblatt 87/31

(84) Benannte Vertragsstaaten :
CH DE FR GB IT LI NL SE

(56) Entgegenhaltungen :
FR-A- 1 587 175
GB-A-   820 687
US-A- 3 678 419
US-A- 4 196 467
JEE JOURNAL OF ELECTRONIC ENGINEERING,
Band 18, Nr. 174, Juni 1981, Seiten 38-42, Tokyo, JP S.
SATOH : "Noise reduction measures increasingly
necessary"

(73) Patentinhaber : Siemens Aktiengesellschaft Berlin
und München
Wittelsbacherplatz 2
D-8000 München 2 (DE)

(72) Erfinder : Kinzler, Hans, Dipl.-Ing.
Roter Brach Weg 69
D-8400 Regensburg (DE)

EP 0 113 465 B1

## Beschreibung

Die Erfindung betrifft ein elektrisches Entstörfilter mit einem Filtergehäuse mit Gehäusedeckel, in das eine mit in Vergußmasse eingebetteten elektrischen Bauelementen, insbesondere Kapazitäten und Induktivitäten bestückte und mit diesen verschaltete Leiterplatte eingesetzt ist, die an Stromanschlußstecker in der Gehäusewand angeschaltet ist.

Bei üblichen Entstörfiltern dieser Art ist das Filtergehäuse mit seinem Gehäuseboden auf eine Bodenplatte aufgesetzt, z. B. aufgeschweißt, die zur Befestigung des Entstörfilters auf einer Schaltungsplatine mit Befestigungslaschen ausgerüstet ist. Die Verschaltung und Anordnung der elektrischen Bauelemente des Entstörfilters erfolgt je nach Stückzahl auf einer Leiterplatte, mittels Lötrahmen oder auch in freier Verdrahtungsweise. Die Entstörfilter — Ein- und Ausgänge sind an Stromanschlußstecker, die bevorzugt in der Gehäusewand angeordnet sind, angeschaltet. Die Stromanschlußstecker können dabei als Gerätestecker oder Flachstecker ausgebildet sein. Auch der am Gehäuse befestigte Schutzleiteranschluß ist üblicherweise ein Flachstecker, der mit einem Laschenteil auf die Gehäuseaußenwand z. B. aufgeschweißt ist.

Ein Entstörfilter üblicher Bauart ist beispielsweise aus der US-Patentschrift US-A 3,678,419 bekannt. Bei der Herstellung dieses Entstörfilters muß unter anderem eine zentrale Öffnung nach dem Füllen des Gehäuses mit Gas durch eine Verschlußscheibe gasdicht verschlossen werden und eine Federklemme, die einen Ferrit-Topf fixiert, in eine hierfür ausgebildete Nut in die Bodenplatte eingepaßt werden. Der für diesen Aufbau notwendige Fertigungsaufwand führt jedoch zu hohen Herstellungskosten.

Der Erfindung liegt die Aufgabe zugrunde, ein Entstörfilter der eingangs genannten Art zu schaffen, das aufgrund seines Aufbaus, d. h. insbesondere aufgrund besonderer Ausbildung einzelner aktiver und passiver Bauelemente einfach und kostensparend herstellbar und auch für die Bildung ganzer Entstörfilterreihen im sogenannten Baukastensystem geeignet ist.

Zur Lösung dieser Aufgabe sieht die Erfindung bei einem elektrischen Entstörfilter gemäß Oberbegriff des Patentanspruchs 1 vor, daß die Leiterplatte auf im Filtergehäuse angeordneten Schenkeln der Steckerstifte der Stromenschlußstecker aufliegt und die zugehörigen Leiterbahnen der Leiterplatte mit diesen Schenkeln elektrisch leitend verbunden sind.

Die Stromanschlußstecker können z. B. als L-förmige Flachstecker ausgebildet sein, deren im Filtergehäuse angeordnete Schenkel wahlweise mit den Leiterbahnen der Leiterplatte elektrisch kontaktiert sind und als Auflager für die Leiterplatte dienen. Sind die Stromanschlußstecker als Gerätestecker ausgebildet, so sind deren im Filtergehäuse angeordnete Schenkel der Steckerstifte vorzugsweise rechtwinklig zu den nach außen gekehrten Schenkeln der Steckerstifte abgewinkelt und gleichfalls als Flachstecker gestaltet.

Bevorzugt sind dabei die Enden der im Filtergehäuse angeordneten Schenkel der Steckerstifte abgestuft und in Schlitze der Leiterplatte eingetaucht, derart, daß ihre zurückgesetzten Stirnkanten als Auflager für die Leiterplatte dienen und ihre in den Schlitzen geführten, vorspringenden Teile mit Leiterbahnen der Leiterplatte elektrisch leitend verbunden, insbesondere verlötet sind.

Bei der Montage der Entstörfilter werden zunächst die elektrischen Bauelemente auf die Leiterplatte, die zweckmäßigerweise mit rasterartig angeordneten Durchbrechungen für die Stromanschlußelemente der elektrischen Bauelemente ausgebildet ist, aufgesteckt und z. B. mittels Schwallöten mit den Leiterbahnen der Leiterplatte elektrisch kontaktiert. Die Leiterplatte gewährleistet so die hochfrequenzgerechte Anordnung der elektrischen Bauelemente und die Einhaltung der erforderlichen Luft- und Kriechwege. Das Aufstecken der bestückten Leiterplatte auf die Enden der im Filtergehäuse angeordneten Schenkel der Steckerstifte erfolgt so, daß die Bauelemente zum Gehäuseinneren und die Leiterbahnen zum Bearbeiter gekehrt und damit frei zugänglich sind, was eine mühelose elektrische Kontaktierung der in die Leiterplattenschlitze eintauchenden Schenkelenden mit den Leiterbahnen ermöglicht. Die Schenkel sind bevorzugt flache Metallbleche. Denkbar sind jedoch auch Schenkel mit kreischeibenförmigem Querschnitt, deren freie Stirnenden abgestuft sind und in entsprechende, z. B. halbkreisscheibenförmige Leiterplattendurchbrechungen eintauchen.

Ist — wie vorstehend dargelegt — die Leiterplatte benachbart zur offenen und durch einen Gehäusedeckel schließbaren Filtergehäuseseite angeordnet, so können die zur Ableitung hochfrequenter Störströme dienenden Y-Kondensatoren der Entstörfilter kürzestmöglich gegen Masse geschaltet werden, was eine optimale Entstörwirkung ergibt.

Die Anschaltung der Y-Kondensatoren an Masse bzw. an die Gehäusewand erfolgt dabei zweckmäßigerweise über flexible, bandförmige Kupferlaschen, deren eine Enden mit entsprechenden Leiterbahnen der Leiterplatte kontaktiert sind und deren andere Enden um die offenen Stirnränder des Filtergehäuses geklappt, zwischen dieses und den Gehäusedeckel geklemmt und z. B. mittels Ultraschall-Schweißen mit dem Filtergehäuse und Gehäusedeckel elektrisch leitend verbunden werden.

Da die Leiterplatte eine exakte Ausrichtung der einzelnen elektrischen Bauelemente zueinander ermöglicht, kann das Entstörfilter mit nichtkonfektionierten Kondensatoren, d. h. mit sogenannten Nacktwickeln, also mit Kondensatoren bestückt werden, die nicht in gesonderte und vergossene Becher eingesetzt sind.

Zweckmäßigerweise ist die Leiterplatte zusätzlich zu ihren Bohrungen für die Stromanschlußelemente mit weiteren größeren Bohrungen ausgestattet, durch die das Vergußmittel, insbesondere Kunstharz, und der Fülle, z. B. Quarzsand, ohne Schwierigkeiten in den Becher eingefüllt werden können. Die Leiterplatte verhindert hierbei im übrigen das Hochschwappen des noch nicht ausgehärteten Vergusses und damit die ansonsten beim Verschweißen des Gehäusedeckels mit dem Filtergehäuse störende Verschmutzung des Filtergehäuses in seinem offenen Gehäuserandbereich.

Im Unterschied zu bisher bekannten Filtergehäusen für Entstörfilter ist der Gehäusedeckel einstückig mit Befestigungslaschen verbunden, die mit Bohrungen für die Halterung des Entstörfilters z. B. auf einer Schaltungsplatine versehen sind. Die Befestigungslaschen können dabei, und zwar je nach gewünschter Ausrichtung der Entstörfilter, wahlweise längs oder quer zur Gehäuselängsrichtung angeordnet sein.

Eine Entstörfilterreihe z. B. von 1 bis 20 A mit verschiedenen elektrischen Bauelementen für unterschiedliche Dämpfungen sollte möglichst rationell und einheitlich für mittlere und kleinere Stückzahlen aufgebaut sein. Zusätzlich sollte, um dieser Forderung zu genügen, auch die Lage des elektrischen Anschlusses und die Befestigungsmöglichkeit des Filtergehäuses variabel sein.

Für die Fertigung ganzer Entstörfilterreihen im sog. Baukastensystem, d. h. für die Fertigung von Entstörfilterreihen, bestehend aus einzelnen Entstörfiltern unterschiedlicher Dämpfung, wird daher vorgeschlagen, daß die Filtergehäuse, Gehäusedeckel und Leiterplatten der Entstörfilter einer Reihe jeweils gleiche Breite, jedoch je nach geforderter Dämpfung und damit Bauelementeanzahl unterschiedlicher Länge haben, daß die Befestigungslaschen der Gehäusedeckel in ihrer Ebene parallel sowie jeweils in gleichem Abstand zur Ebene der Gehäusedeckel versetzt sind, und daß die Längen der im Filtergehäuseinneren angeordneten Schenkel der Steckerstifte und der Abstand zwischen Stromanschlußstecker-Gehäusewanddurchführungen und Filtergehäuse-Stirnwand jeweils so gewählt sind, daß die Leiterplatten sämtlicher Entstörfilter einer Reihe gleichen Abstand zum Gehäusedeckel haben.

Die Einhaltung dieser Forderung führt zu erheblichen fertigungstechnischen Vereinfachungen, insbesondere können die zur Herstellung der Entstörfilter notwendigen Vorrichtungen auf ein Minimum begrenzt und darüberhinaus mit optimaler Wirkung eingesetzt werden.

Die Erfindung wird nachstehend anhand mehrerer in der Zeichnung dargestellter Ausführungsbeispiele näher erläutert. Es zeigt :

Figur 1 eine Seitenansicht eines ersten Ausführungsbeispiels eines Entstörfilters nach der Erfindung in teilweise geschnittener Darstellung,

Figur 2 eine Draufsicht auf das Entstörfilter nach Fig. 1, wobei der Gehäusedeckel abgenommen ist und die elektrischen Bauelemente des Entstörfilters strichliniert angedeutet sind,

Figur 3 eine Draufsicht auf den Gehäusedeckel nach Fig. 1,

Figur 4 eine Draufsicht auf ein geändertes Ausführungsbeispiel eines Gehäusedeckels,

Figur 5 eine Seitenansicht des Filtergehäuses nach Fig. 1, 2, wobei lediglich der Schutzleiter-Flachsteckeranschluß dargestellt ist,

Figur 6 in der Darstellung nach Fig. 1 ein zweites Ausführungsbeispiel eines Entstörfilters nach der Erfindung,

Figur 7 einen Schnitt gemäß der Linie AA nach Fig. 6 durch einen erfindungsgemäß gestalteten Gerätestecker.

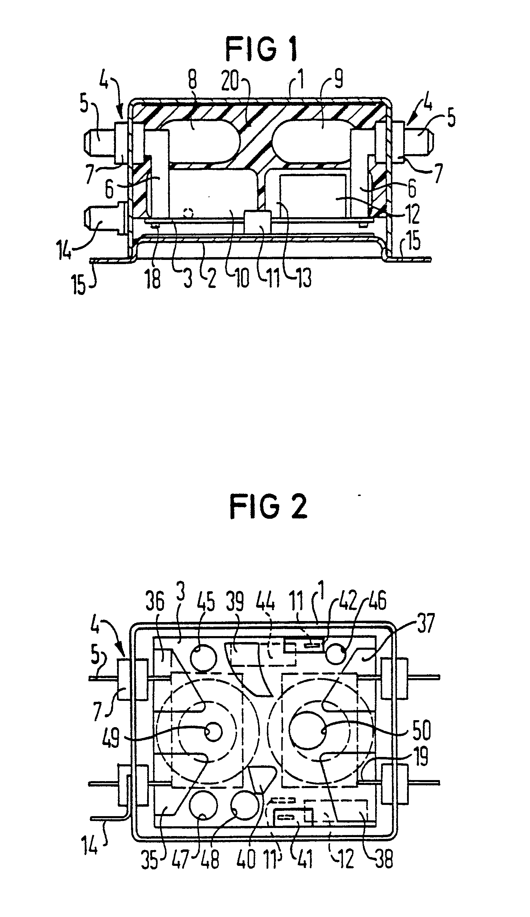

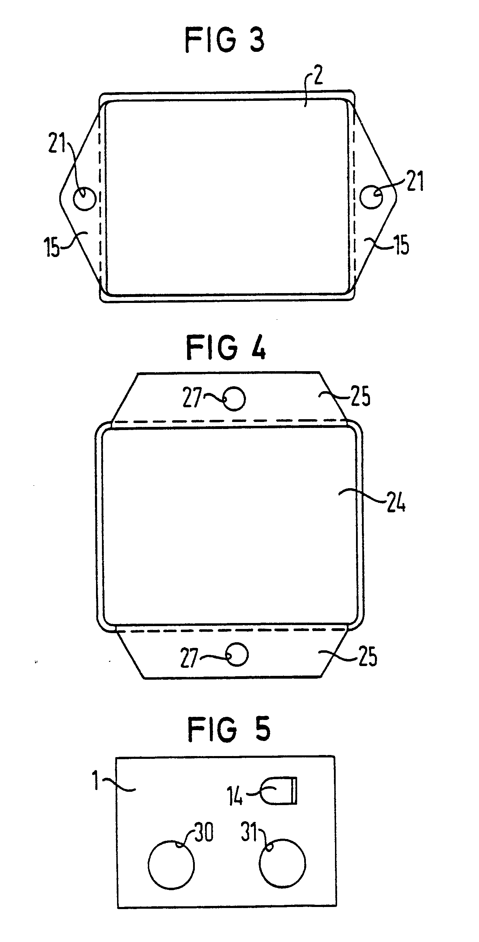

Das Entstörfilter gemäß Fig. 1, 2 besitzt ein Filtergehäuse 1 und einen Gehäusedeckel 2, die beide, da dies sehr kostensparend ist und zusätzlich zu guten Hochfrequenzeigenschaften führt, aus Aluminium gefertigt werden. Mit 14 ist ein Schutzleiter-Flachsteckeranschluß bezeichnet, der zweckmäßigerweise bei sämtlichen Entstörfiltern an der gleichen, z. B. in Fig. 5 dargestellten Stelle des Filtergehäuses 1 befestigt ist. Fertigungstechnisch entfällt damit die Notwendigkeit je nach unterschiedlicher Positionierung des Flachsteckeranschlusses die für die Steckerbefestigung erforderlichen Werkzeuge umzurüsten.

Der Gehäusedeckel 2 ist gemäß Fig. 1 und 3 einstückig mit Befestigungslaschen 15 verbunden, die beispielsweise zur Befestigung des Entstörfilters auf einer Schaltungsplatine mit Bohrungen 21 versehen sind. Wahlweise kann dieser Gehäusedeckel durch den in Fig. 4 gezeigten Gehäusedeckel 24 ersetzt werden, der um 180° versetzte Befestigungslaschen 25 samt Bohrungen 27 aufweist.

In Bohrungen 30, 31 (siehe Fig. 5) einander gegenüberliegender Seitenwände des Filtergehäuses 1 sind mittels Isolierteilchen 7 gehaltene L-förmige Flachstecker 4 mit Schenkeln 5, 6 eingesetzt. Die Schenkel 6 dienen zusätzlich zum Stromanschluß auch als Auflager für eine Leiterplatte 3. Die freien Enden der Schenkel 6 sind zu diesem Zweck abgestuft und tauchen mit ihren vorspringenden Stirnkanten 18 jeweils in Schlitze 19 der Leiterplatte 3 ein, derart, daß ihre zurückgesetzten Stirnkanten als Auflager für die Leiterplatte 3 dienen.

Die Leiterplatte 3 trägt auf ihrer zum Gehäusedeckel 2 gekehrten Seitenfläche Leiterbahnen 39, 40, 41 und 42, und Leiterbahnen 35, 36, 37, 38, die mit den Schenkeln 6 der Flachstecker 4 elektrisch kontaktiert sind. Die Leiterplatte 3 besitzt in den Leiterbahnbereichen Durchbrechungen für die Stromanschlußelemente der elektrischen Bauelemente, nämlich Kapazitäten 8, 9 Ringkerndrosseln 10, 13 und Y-Kondensatoren 12, 44. Die Y-Kondensatoren 12, 44, die zur Ableitung hochfrequenter Störströme dienen, liegen über die Leiterbahnen 41, 42 und über mit diesen Leiterbahnen kontaktierten flexiblen, bandförmigen Kupferlaschen 11 gegen Masse. Die Kupferlaschen 11 sind dabei aus dem Filtergehäuseinneren herausgeführt, zwischen das Filtergehäuse 1 und den Gehäusedeckel 2 geklemmt und mittels.

Ultraschall-Schweißen mit dem Filtergehäuse 1 bzw. mit dem Gehäusedeckel 2 elektrisch leitend verbunden.

Zur Einbettung der Elemente des Entstörfilters in eine Vergußmasse 20 ist die Leiterplatte 3 mit Durchbrechungen 45 bis 50 ausgestattet, deren Anordnung und Größe so gewählt ist, daß die Zufuhr des Vergußmittels, z. B. Gießharz, und des Füllmittels, z. B. Quarzsand, in das Gehäuseinnere ohne Schwierigkeiten erfolgen kann.

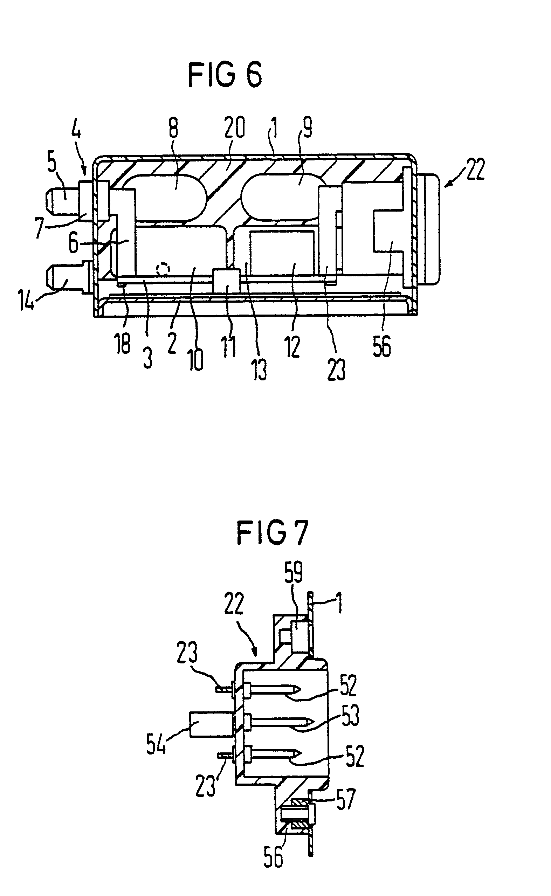

Beim Ausführungsbeispiel nach Fig. 6 und 7, bei dem im übrigen gleiche Teile mit gleichen Bezugszeichen bezeichnet sind, sind die in Fig. 1 rechtsseitig dargestellten Flachstecker 4 durch einen Gerätestecker 22 ersetzt. Dieser Gerätestecker besitzt einstückige Anformungen 56 mit Sacklöchern 59, in die Gewindebuchsen 57 eingebettet sind. Die Gewindebuchsen 57 sind in die Durchbrechungen des Filtergehäuses 1 plan eingenietet, so daß der Gerätestecker 22 mit dem Filtergehäuse 1 fest verbunden ist. Die im Filtergehäuse-Inneren angeordneten Schenkel 23, 54 der Steckerstifte 32, 53 des Gerätesteckers sind im gezeigten Ausführungsbeispiel als Flachstecker ausgebildet. Die freien Enden der Schenkel 23 sind — wie dies beim Ausführungsbeispiel nach Fig. 1, 2 der Fall ist — gleichfalls abgestuft und in entsprechende Schlitze der Leiterplatte 3 eingetaucht, derart, daß ihre zurückgesetzten Stirnkanten als Auflager für die Leiterplatte 3 dienen. Der Schenkel 54 dient entsprechend dem Flachstecker 14 nach Fig. 1 ebenfalls als Schutzleiteranschluß, der mit dem Filtergehäuse 1 z. B. durch Ultraschallschweißen elektrisch kontaktiert ist.

Die beschriebenen Entstörfilter eignen sich in ausgezeichnetem Maße zur Serienfertigung und insbesondere zur Herstellung ganzer Entstörfilterreihen im sog. Baukastensystem. Die Montage, insbesondere auch die elektrische Kontaktierung der Stromanschlußstecker mit der Leiterplatte und die Befestigung der Kupferlaschen am Filtergehäuse ist einfach und auch ohne große Umrüstung bei unterschiedlichen Entstörfilterreihen durchführbar.

**Patentansprüche**

1. Elektrisches Entstörfilter mit einem Filtergehäuse mit Gehäusedeckel, in das eine mit in Vergußmasse eingebetteten elektrischen Bauelementen, insbesondere Kapazitäten und Induktivitäten, bestückte Leiterplatte eingesetzt ist, die über Leiterbahnen die Bauelemente mit Stromanschlußsteckern in der Gehäusewand elektrisch verbindet, dadurch gekennzeichnet, daß die Leiterplatte (3) auf im Filtergehäuse (1) angeordneten Schenkeln (6 bzw. 23) der Steckerstifte der Stromanschlußstecker (4 bzw. 22) aufliegt und die zugehörigen Leiterbahnen (35, 36, 37, 38) der Leiterplatte (3) mit diesen Schenkeln elektrisch leitend verbunden sind.

2. Elektrisches Entstörfilter nach Anspruch 1, dadurch gekennzeichnet, daß die Stromanschlußstecker insbesondere als L-förmige Flachstecker (4) ausgebildet sind, deren im Filtergehäuse (1) angeordnete Schenkel (6) wahlweise mit den Leiterbahnen (35, 36, 37, 38) der Leiterplatte (3) elektrisch kontaktiert sind und als Auflager für die Leiterplatte (3) dienen.

3. Elektrisches Entstörfilter nach Anspruch 1, dadurch gekennzeichnet, daß als Stromanschlußstecker Gerätestecker (22) vorgesehen sind, deren im Filtergehäuse (1) angeordnete Schenkel (23) der Steckerstifte vorzugsweise rechtwinklig zu den nach außen gekehrten Schenkeln (52) dieser Steckerstifte abgewinkelt und als Flachstecker ausgebildet sind.

4. Elektrisches Entstörfilter nach Anspruch 1, 2 oder 3, dadurch gekennzeichnet, daß die Enden der im Filtergehäuse (1) angeordneten Schenkel (6, 23) der Steckerstifte abgestuft sind und in Schlitze (19) der Leiterplatte (3) eintauchen, derart, daß ihre zurückgesetzten Stirnkanten als Auflager für die Leiterplatte dienen.

5. Elektrisches Entstörfilter nach Anspruch 1, 2, 3 oder 4, dadurch gekennzeichnet, daß die Enden der Schenkel (6, 23) der Steckerstifte mit ihren in die Schlitze (19) der Leiterplatte (3) eintauchenden Teilen (18) mit den Leiterbahnen (35, 36, 37, 38) der Leiterplatte (3) verlötet sind.

6. Elektrisches Entstörfilter nach Anspruch 1, 2 3, 4 oder 5, gekennzeichnet durch zusätzliche Leiterbahnen (41, 42), die zur Ableitung hochfrequenter Störströme an Y-Kondensatoren (12, 44) angeschaltet sind und über flexible, bandförmige Kupferlaschen (11) gegen Masse liegen, derart, daß die Laschen aus dem Gehäuseinnern herausgeführt, zwischen Filtergehäuse (1) und Gehäusedeckel (2) geklemmt und insbesondere mittels Ultraschall-Schweißen mit dem Filtergehäuse und Gehäusedeckel elektrisch leitend verbunden sind.

7. Elektrisches Entstörfilter nach Anspruch 1, 2, 3, 4, 5 oder 6, dadurch gekennzeichnet, daß der Gehäusedeckel (2, 24) einstückig mit Befestigungslaschen (15, 25) verbunden ist, die mit Bohrungen (21, 27) versehen sind.

8. Entstörfilterreihe, bestehend aus einzelnen Entstörfiltern unterschiedlicher Dämpfung, gemäß einem der vorhergehenden Patentansprüche, dadurch gekennzeichnet, daß die Filtergehäuse (1), Gehäusedeckel (2) und Leiterplatten (3) der Entstörfilter einer Reihe jeweils gleiche Breite, jedoch je nach geforderter Dämpfung und damit Bauelementeanzahl unterschiedliche Länge haben, daß die Befestigungslaschen (15, 25) der Gehäusedeckel (2) in ihrer Ebene parallel sowie jeweils in gleichem Abstand zur Ebene der Gehäusedeckel versetzt sind, und daß die Längen der im Filtergehäuseinneren angeordneten Schenkel (6, 23) der Flachund Gerätestecker (4) bzw. (22) und der Abstand zwischen Stromanschlußstecker-Gehäusewanddurchführungen (30, 31) und Filtergehäusestirnwand jeweils so gewählt sind, daß die Leiterplatten sämtlicher Entstörfilter einer Reihe gleichen Abstand zum Gehäusedeckel (2) haben.

## Claims

1. An electrical interference suppression filter having a filter housing with a housing cover, in which is set a printed circuit board equipped with electrical components embedded in the filter, in particular capacitors and inductors, which circuit board connects the components via circuit paths with electrical plugs in the housing wall, characterised in that the printed circuit board (3) is supported in the filter housing (1) by limbs (6 or 23) of the pins of the plugs (4 or 22) and the appropriate circuit paths (35, 36, 37, 38) of the circuit board (3) are electrically connected with these limbs.

2. An electrical interference suppression filter as claimed in Claim 1, characterised in that the plugs are constructed as flat, L-shaped plugs (4), with their limbs arranged in the filter housing (1) to make selective electrical contact with the circuit paths (35, 36, 37, 38) of the circuit board (3) and serve as a support for the circuit board (3).

3. An electrical interference suppression filter as claimed in Claim 1, characterised in that the plugs are provided as apparatus plugs (22) positioned in the filter housing (1) with the limbs (23) of their pins at right angles to the limbs (52) of these pins, which are constructed as flat plugs turned outwardly.

4. An electrical interference suppression filter as claimed in Claim 1, 2 or 3, characterised in that the ends of the limbs (6, 23) of the plug pins in the filter housing (1) are graduated and arranged in slots (19) in the circuit board (3) such that their turned-back front edges serve as supports for the circuit board.

5. An electrical interference suppression filter as claimed in Claim 1, 2, 3 or 4, characterised in that the ends of the limbs (6, 23) of the plug pins are soldered to the circuit paths (35, 36, 37, 38) of the circuit board with their parts (18) arranged in the slots (19) of the circuit board (3).

6. An electrical interference suppression filter as claimed in Claim 1, 2, 3, 4 or 5, characterised by additional circuit paths (41, 42), connected to Y-capacitors (12, 44) to shunt to earth highfrequency interference currents via flexible ribbon-shaped copper straps (11), the straps being led out of the housing interior, between the filter housing (1) and the housing cover (2) and, in particular connected electrically with the filter housing and housing cover by ultrasonic welding.

7. An electrical interference suppression filter as claimed in Claim 1, 2, 3, 4, 5 or 6, characterised in that the housing cover (2, 24) is connectively sealed by mounting plates (15, 25) having bored holes (21, 27).

8. A sequence of interference suppression filters, consisting of individual interference suppression filters of varying attenuation, as claimed in any preceding Claim, characterised in that the filter housings (1), housing covers (2), and circuit boad (3) of the interference suppression filters of any given series have the same width, but a varying attenuation, according to the required length, and hence a differing number of components, that in each case the mounting plates (15, 25) of the housing covers (2) are parallel and offset at the same distance from the plane of the housing cover and the lengths of the limbs (6, 23) of the flat and apparatus plugs (4 or 22 as the case may be) positioned inside the filter housing, and the distance between the leadthrough connections (30, 31) in the plug housing wall and the front wall of the filter housing are in each case selected such that the circuit boards of all the interference suppression filters of a series are at the same distance from their housing cover (2).

## Revendications

1. Filtre électrique antiparasites, comportant un boîtier de filtre avec un couvercle, dans lequel est placée une plaquette à circuits imprimés, qui est garnie de composants électriques noyés dans une masse de scellement, en particulier de capacités et d'inductances, et qui, par des pistes conductives, relie les composants électriques à des connecteurs de raccordement de courant à enfichage dans la paroi du boîtier, caractérisé en ce que la plaquette à circuits imprimés (3) repose sur des branches (6 respectivement 23) des broches des connecteurs de raccordement (4 respectivement 22), branches qui sont disposées à l'intérieur du boîtier (1) du filtre, et les pistes conductives (35, 36, 37, 38) correspondantes de la plaquette à circuits imprimés (3) sont reliées électriquement à ces branches.

2. Filtre selon la revendication 1, caractérisé en ce que les connecteurs de raccordement sont réalisés en particulier comme des broches plates (4) de forme en L, dont les branches (6) disposées dans le boîtier (1) du filtre sont sélectivement reliées électriquement aux pistes conductives (35, 36, 37, 38) de la plaquette à circuits imprimés (3) et servent d'appuis à cette plaquette.

3. Filtre selon la revendication 1, caractérisé en ce que les connecteurs de raccordement sont constitués par un connecteur d'appareil (22) dont les branches (23) des broches disposées dans le boîtier (1) du filtre sont, de préférence, coudées à angle droit par rapport aux branches (52) dirigées vers l'extérieur de ces broches, et sont réalisées sous forme de broches plates.

4. Filtre selon la revendication 1, 2 ou 3, caractérisé en ce que les extrémités des branches (6, 23) des broches disposées dans le boîtier (1) du filtre, sont étagées et pénètrent dans des fentes (19) de la plaquette à circuits imprimés (3), de manière que les parties disposées en retrait de leurs bords extrêmes servent d'appuis à la plaquette à circuits imprimés.

5. Filtre selon la revendication 1, 2, 3 ou 4, caractérisé en ce que les extrémités des branches (6, 23) des broches sont brasées, par leurs parties saillantes (18) pénétrant dans les fentes (19) de la plaquette à circuits imprimés (3), aux pistes conductives (35 à 38) de cette plaquette.

6. Filtre selon la revendication 1, 2, 3, 4 ou 5, caractérisé par des pistes conductives supplémentaires (41, 42) qui sont reliées à des condensateurs en Y (12, 44) pour l'élimination de courants perturbateurs à haute fréquence et sont reliées à la masse par des languettes souples en cuivre (11), languettes qui sont sorties de l'intérieur du boîtier (1), pincées entre ce boîtier et le couvercle (2) et reliées électriquement au boîtier et au couvercle, en particulier au moyen d'un brasage par ultrasons.

7. Filtre selon la revendication 1, 2, 3, 4, 5 ou 6, caractérisé en ce que le couvercle (2, 24) du boîtier est relié d'un seul tenant à des pattes de fixation (15, 25) qui sont pourvues de trous (21, 27).

8. Banc de filtres antiparasites, constitué de filtres antiparasites individuels produisant des atténuations différentes, selon une des revendications précédentes, caractérisé en ce que les boîtiers de filtre (1), leurs couvercles (2) et les plaquettes à circuits imprimés (3) des filtres antiparasites d'un banc possèdent la même largeur, mais des longueurs différentes suivant l'atténuation requise et, partant, suivant le nombre des composants, que les pattes de fixation (15, 25) des couvercles (2) sont décalées dans leur plan, parallèlement et chaque fois à la même distance du plan des couvercles, et que les longueurs des branches (6, 23) disposées à l'intérieur des boîtiers de filtre des connecteurs à broches plates et d'appareil (4 respectivement 22), de même que la distance entre les traversées (30, 31) des connecteurs de raccordement à travers la paroi du boîtier d'une part et la paroi extrême du boîtier de filtre d'autre part, sont chaque fois choisies de manière que les plaquettes à circuits imprimés de tous les filtres antiparasites d'un banc se trouvent à la même distance du couvercle (2) du boîtier.

# FIG 1

# FIG 2

# FIG 3

21

2

21

15

15

# FIG 4

27

25

24

27

25

# FIG 5

1

14

30

31

# FIG 6

# FIG 7